# EUROPEAN PATENT APPLICATION

(11) **EP 2 830 399 A1**
(43) Date of publication of application: **28.01.2015**
(21) Application number: 13306059.0
(22) Date of filing: 23.07.2013
(51) Int. Cl.: H05K 1/02, H05K 3/40

(54) **Printed circuit board cooling**

(71) Applicant: ALCATEL LUCENT, 92100 Boulogne-Billancourt (FR)
(72) Inventor: Marcerou, Jean-François, 91620 Nozay (FR); Guisy, Christine, 91620 Nozay (FR); Verhaege, Thierry, 91620 Nozay (FR)
(74) Representative: MERH-IP Matias Erny Reichl Hoffmann

(57) **Abstract**

The invention relates to a printed circuit board assembly (10) comprising a printed circuit board (2) including at least one copper plane (11) and supporting a plurality of electronic components (3) electrically connected to at least one copper plane (11), a thermally conducting chassis (4) extending substantially parallel to the printed circuit board (2), a thermal pad (5) substantially filling a gap between the printed circuit board (2) and the chassis (4) so as to enable heat transfer from the printed circuit board (2) to the chassis (4), and a plurality of thermally conducting pins (12) extending from the at least one copper plane (11) towards the chassis (4) so as to penetrate the thermal pad (5).

## Description

### TECHNICAL FIELD

The present invention relates to the field of printed circuit board assemblies. More particularly, the invention concerns a printed circuit board assembly enabling improved heat transfer.

### BACKGROUND

Printed circuit boards (PCBs) support electronic components and include wiring and soldering tracks. In order to function correctly and to optimize the lifetime of the components, the heat generated by the components in operation has to be dissipated properly.

Several techniques are employed to transfer heat from the PCB to its environment. For example, heat may be transferred by natural air cooling. However, the cooling effect may be insufficient for some applications. Forced air cooling, for example in the form of a fan blowing air onto the PCB, may be prohibited for reliability reasons, in particular in the case of PCBs being part of subsea equipment.

Heat may also be transferred by conduction from the PCB to its support. This is usually the case for subsea equipment. The support is typically a chassis fixed to the sea case containing the PCB(s) and onto which the PCB(s) are clamped, screwed, or otherwise fixed. The heat conduction method must respond to several constraints. For example, electric isolation shall generally be maintained between the PCB and the support. Further, the PCB surface is normally scattered with electronic components, tracks, soldering areas, and the like, which can prevent a good thermal contact of the PCB with the support.

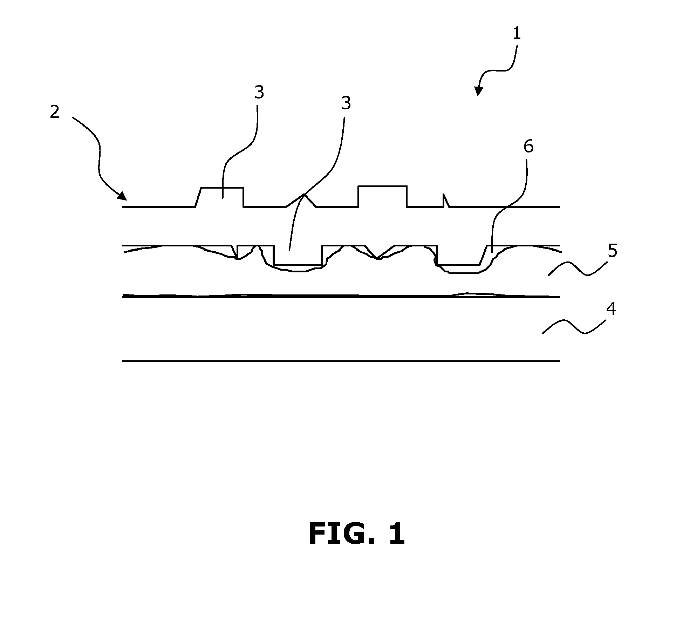

A known printed circuit board assembly 1 employing heat conduction cooling is represented in Fig. 1. A thick thermally conductive, or thermal pad 5 is fitted between a PCB 2 and its support 4, or chassis. The PCB 2 supports multiple heat dissipating, electronic components 3, wiring, soldering spots, etc., leading to surfaces of the PCB 2 having a roughness of several millimeters. The thermal pad 5 is of a thermally conducting material and transfers the heat from the PCB 2 to its support 4, which acts as a heat sink. Thanks to its deformability increasing with temperature, the thermal pad 5 is normally used to fill air gaps between the PCB 2 and the support 4.

However, thermal pads are usually not compressible and deformable enough so as to come reliably in close contact with all parts of the PCB, in spite of possible PCB deformations, bumps, vibrations, or differential shrinkage. Thus, air gaps 6, as illustrated in Fig. 1, may persist between the thermal pad 5 and the PCB 2. Further, the positioning of the thermal pads may vary in time, they may undergo debonding from the PCB, and the materials used for the thermal pads are subject to ageing, which greatly compromises their reliability.

Another heat transfer arrangement employs a metal core PCB technology, which consists in directly integrating an electrically insulated metallic piece into the PCB. The metallic core is linked to an external heat sink to conduct heat away from the PCB. Even though this technique shows good thermal performance, it implies, however, a very sophisticated and expensive PCB fabrication technology.

According to the foregoing, there exists a need for a printed circuit board assembly providing for an efficient, durable, simple and cost-effective heat conduction cooling.

### SUMMARY OF EXEMPLARY EMBODIMENTS

Embodiments of the present invention provide a printed circuit board assembly enabling improved heat conduction cooling of the printed circuit board and the heat dissipative electronic components arranged on it, wherein the assembly resolves the above mentioned problems.

According to a first aspect, there is provided a printed circuit board assembly printed circuit board assembly comprising:
a printed circuit board including at least one copper plane and supporting a plurality of electronic components electrically connected to the at least one copper plane,
a thermally conducting chassis extending substantially parallel to the printed circuit board,
a thermal pad substantially filling a gap between the printed circuit board and the chassis so as to enable heat transfer from the printed circuit board to the chassis, and
a plurality of thermally conducting pins extending from the at least one copper plane towards the chassis so as to penetrate the thermal pad.

The printed circuit board assembly according to the present disclosure provides a continuous, reliable heat transfer path from the dissipative electronic components to the chassis. The heat is transferred from the electronic components to the at least one copper plane, along the copper plane, from the copper plane to the thermally conducting pins, along the pins and into the thermal pad, and finally from the thermal pad to the chassis. This heat conduction mechanism is reliable even in the absence of a direct or perfect contact of the printed circuit board with the thermal pad.

Preferably, the pins are electrically conducting.

In some embodiments, the chassis is electrically conducting having the same electrical potential as the at least one copper plane, and at least one of the pins connecting to the at least one copper plane is in electrically conducting contact with the chassis.

Alternatively, the printed circuit board includes a plurality of copper planes all similar to and being at the same electrical potential as the at least one copper plane, and wherein at least one pin of each copper plane of the plurality of copper planes is in electrically conducting contact with the chassis.

In some embodiments, a surface of the chassis next to the thermal pad is covered with an electrically insulating varnish and at least one of the pins is in physical contact with the varnished surface.

Preferably, the pins are parallel to each other.

In some embodiments, the pins extend substantially perpendicularly from the at least one copper plane.

In some embodiments, the pins are extending from the at least one copper plane according to a chessboard grid. Advantageously, the pins are spaced between 2 mm and 3.5 mm with respect to each other, and preferably 2 mm, 2.54 mm, or 3.17 mm.

Preferably, the diameter of each of the pins is about 1 mm.

Advantageously, the pins are of copper or aluminum.

In some embodiments, at least one of the plurality of pins is constituted by a lead of one of the plurality of electronic components.

Advantageously, the length of the pins substantially corresponds to an average distance between the printed circuit board and the chassis.

Additional aspects and advantages of printed circuit board assemblies according to embodiments disclosed herein will be set forth, in part, in the detailed description, figures and any claims which follow, and, in part, will be derived from the detailed description. It is to be understood that both the foregoing general description and the following detailed description are only exemplary and do not limit the claimed inventions.

### BRIEF DESCRIPTION OF THE DRAWINGS

Exemplary embodiments of printed circuit board assemblies according to this disclosure are described with reference to the accompanying drawings, in which:
Fig. 1, already described, schematically represents a sectional view of a known printed circuit board assembly;
Fig. 2 schematically represents a sectional view of a printed circuit board assembly according to an embodiment disclosed herein; and
Fig. 3 illustrates heat conduction in a printed circuit board assembly according to embodiments disclosed herein.

### DETAILED DESCRIPTION

The figures and the following description illustrate exemplary embodiments. In the figures, elements with similar structures and/or functions may be denoted by like reference numerals.

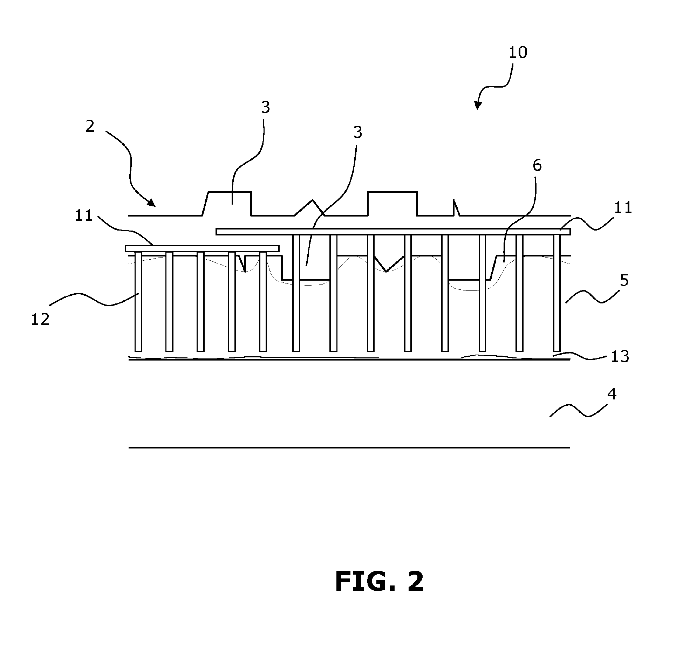

Fig. 2 schematically represents a sectional view of a printed circuit board assembly 10 according to an embodiment disclosed herein. The printed circuit board assembly 10 comprises a printed circuit board (PCB) 2. The PCB 2 includes a non-conductive board consisting of a known material, for example, FR-4. The PCB 2 further includes at least one copper plane 11 and supports a plurality of electronic components 3, which are electrically connected to the copper plane 11. The one or more copper planes 11 are constituted by conductive pathways or tracks that electrically connect the electronic components and are etched from copper sheets laminated onto the non-conductive board. There may also be multiple copper trace layers within the thickness of the board. As shown in the embodiment of Fig. 2, the PCB 2 supports on both sides electronic components, as well as tracks and soldering spots. However, it is also possible that only one side of the PCB 2 is populated.

The electrical circuit implemented by the PCB 2 may comprise several equipotential areas (for example, ground, +15 V, -15 V) that are each electrically linked with a different copper plane 11, covering a large part of the PCB 2 surface. The example of Fig. 2 shows two copper planes 11.

The PCB assembly 10 further comprises a thermally conducting chassis 4 extending substantially parallel to the PCB 2. In the case of the PCB 2 being implemented with subsea equipment, the chassis 4 is used to fix the PCB 2 to the sea case (not shown). A thermal pad 5, substantially filling a gap between the PCB 2 and the chassis 4, enables heat transfer from the PCB 2 to the chassis 4. The thermal pad 5 may be of plastic or silicon-based material, for example, Kapton, which may additionally be paraffin-wax coated. The thermal pad 5 may have a thickness of several millimeters, for example, about 3 mm. The remaining air gaps 6 between the thermal pad 5 and the PCB 2 may be simply expressed as a mean residual air gap of a given width.

The PCB assembly 10 further comprises a plurality of thermally conducting pins 12. The pins 12 extend from the at least one copper plane 11 towards the chassis 4 so as to penetrate the thermal pad 5. The pins 12 constitute a reliable thermally conductive contact between the PCB 2 and the thermal pad 5, even if the thermal pad 5 does not perfectly adapt the surface of the PCB 2. The pins 12 may be attached to the at least one copper plane 11 by soldering.

The PCB 2 is clamped, screwed, or otherwise fixed to the chassis 4. Thereby, the thermal pad 5 is moderately compressed so as to enable it to substantially fill the gap between the PCB 2 and the chassis 4. According to an embodiment, the pins 12 do not touch the chassis 4. Thus, a gap 13 is left between each of the pins 12 and the chassis, as shown in Fig. 2. The pins 12 penetrate the thermal pad 5 over a given distance so as to enable the penetration of substantially all the pins 12 into the pad 5 at any time. The longer the pins 12 in relation to an average distance between the PCB 2 and the chassis 4, the better is the heat conduction performance of the assembly 10. The pins 12 may, for example, end up at about 0.5 mm from the chassis 4. The length of the pins 12 may substantially correspond to an average distance between the printed circuit board (2) and the chassis (4). The pins 12 may all have the same length, or different lengths.

In some embodiments, the pins 12 may be of copper or of aluminum. Copper is an excellent thermal conductor, with a thermal conductivity of about 400 W/(m·K). Aluminum also has good thermal conductivity (of about 235 W/(m·K)) and is a relatively cheap metal. For comparison, the materials used for the thermal pad have thermal conductivities in the range of 1 to 5 W/(m·K), and air 0.03 W/(m·K).

As it will be appreciated by the skilled person, the pins 12 may be electrically conducting. In the case the pins are of metal or metal alloy, a good electrical conductivity is normally correlated with a good thermal conductivity. The spacing between the pins 12 and the chassis 4 thus prevents electrical contact between each of the pins 12 and the chassis 4.

Furthermore, the chassis 4, which acts as a heat sink, may be electrically conducting. For example, the chassis 4 may be of aluminum. In this case, the chassis may be of the same electrical potential as one or more copper planes 11. One or several of the pins 12 connecting to this or these copper planes 11 may then be in electrically conducting contact with the chassis 4.

In some embodiments, a surface of the chassis 4 that is next to the thermal pad 5 may be covered with an electrically insulating varnish. At least one of the pins 12 may then be in physical contact with the varnished surface.

The physical contact of the pins 12 with the chassis 4 may help to correctly position the PCB 2 with respect to the chassis 4 and to enhance the mechanical stability of the PCB assembly 10.

Advantageously, in some embodiments, the pins 12 are parallel to each other. Preferably, the pins 12 extend substantially perpendicularly from the at least one copper plane 11, as with the embodiment shown in Fig. 2.

In some embodiments, the pins 12 may be arranged on the at least one copper plane 11 according to a grid. Preferably, the pins 12 extend from the at least one copper plane 11 according to a chessboard grid. The pins 12 may be spaced between 2 mm and 3.5 mm with respect to each other. The diameter of each of the pins 12 may be about 1 mm. For example, the pins 12 may be spaced 2 mm, 2.54 mm (0.1 in), or 3.17 mm (0.125 in). These spacing values permit to route wirings to other layers in the PCB 2. The pins 12 may, for example, about 2 to 3 mm long.

In some embodiments, at least one of the plurality of pins 12 may be constituted by a lead of one of the plurality of electronic components 3. The pins or leads, typically of copper, of the electronic components 3 are usually cut at the soldering slots of the PCB 2. One or more of them may be maintained longer so as to deeply penetrate the thermal pad 5, such as described hereinabove with respect to the pins 12.

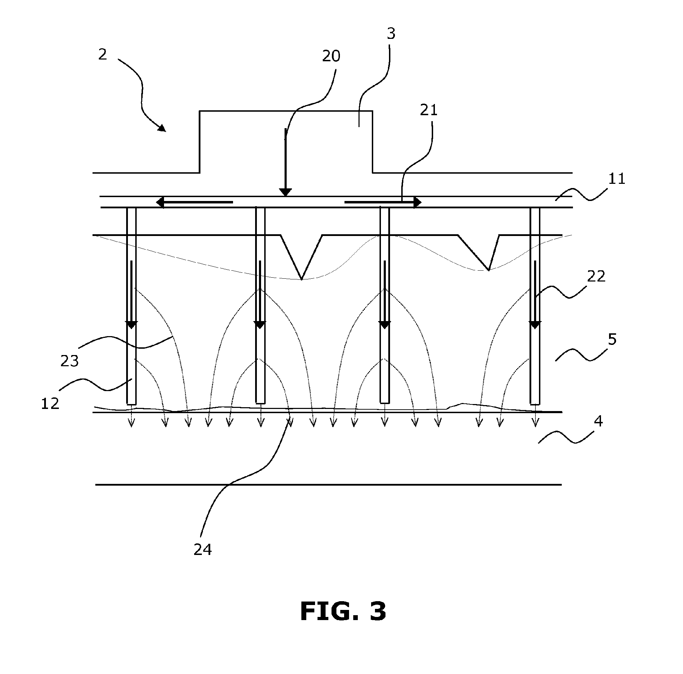

Fig. 3 illustrates the heat transfer occurring in the PCB assembly 10 according to embodiments disclosed herein, in the case the pins 12 do not touch the chassis 4. The heat transfer is schematically indicated by arrows 20-24. The heat is conducted from the electronic components 3 to the at least one copper plane 11 (arrow 20), along the copper plane 11 (arrows 21), from the copper plane 11 to the pins 12, along the pins 12 (arrows 22) and radially into the thermal pad 5 (arrows 23), and finally from the thermal pad 5 to the chassis 4 (arrows 24). In the case the pins 12 touch the chassis, the heat conduction figure is similar, with additional direct heat conduction from the pins 12 to the chassis 4. From the chassis 4, the heat may then be transferred, for example, to the sea case and into the water (not shown).

For a typical PCB 2, heat transfer performances may be estimated to the following average values:
- natural convection: 10 W/(m²·K),
- forced convection using an air fan: 100 W/(m²·K),
- known PCB assembly having a thermal pad of a thickness of about 3 mm with a mean residual air gap of about 0.2 mm between the thermal pad and the PCB: 100 W/(m²·K),
- PCB assembly according to embodiments disclosed herein (pins of about 1 mm in diameter, spaced 2.54 mm (0.1 in), and ending up at about 0.5 mm from the chassis): 1000 W/(m²·K).

The heat conduction mechanism as described above is reliable and efficient even in the absence of a direct or perfect contact of the printed circuit board with the thermal pad. The printed circuit board assembly according to the present disclosure provides a continuous, reliable heat transfer path from the dissipative electronic components to the chassis.

Although some embodiments of the present invention have been illustrated in the accompanying drawings and described in the foregoing detailed description, it should be understood that the present invention is not limited to the disclosed embodiments, but is capable of numerous rearrangements, modifications, and substitutions without departing from the invention as set forth and defined by the following claims.

## Claims

1. A printed circuit board assembly (10) comprising:
a printed circuit board (2) including at least one copper plane (11) and supporting a plurality of electronic components (3) electrically connected to the at least one copper plane (11),
a thermally conducting chassis (4) extending substantially parallel to the printed circuit board (2),
a thermal pad (5) substantially filling a gap between the printed circuit board (2) and the chassis (4) so as to enable heat transfer from the printed circuit board (2) to the chassis (4), and
a plurality of thermally conducting pins (12) extending from the at least one copper plane (11) towards the chassis (4) so as to penetrate the thermal pad (5).

2. The printed circuit board assembly (10) according to claim 1, wherein the pins (12) are electrically conducting.

3. The printed circuit board assembly (10) according to claim 2, wherein the chassis (4) is electrically conducting having the same electrical potential as the at least one copper plane (11), and wherein at least one of the pins (12) connecting to the at least one copper plane (11) is in electrically conducting contact with the chassis (4).

4. The printed circuit board assembly (10) according to claim 3, wherein the printed circuit board (2) includes a plurality of copper planes all similar to the at least one copper plane (11) and being at the same electrical potential as the at least one copper plane (11), and wherein at least one pin (12) of each copper plane of the plurality of copper planes is in electrically conducting contact with the chassis (4).

5. The printed circuit board assembly (10) according to claim 1 or 2, wherein a surface of the chassis (4) next to the thermal pad (5) is covered with an electrically insulating varnish and at least one of the pins (12) is in physical contact with the varnished surface.

6. The printed circuit board assembly (10) according to any of the preceding claims, wherein the pins (12) are parallel to each other.

7. The printed circuit board assembly (10) according to any of the preceding claims, wherein the pins (12) extend substantially perpendicularly from the at least one copper plane (11).

8. The printed circuit board assembly (10) according to any of the preceding claims, wherein the pins (12) are extending from the at least one copper plane (11) according to a chessboard grid.

9. The printed circuit board assembly (10) according to claim 8, wherein the pins (12) are spaced between 2 mm and 3.5 mm with respect to each other.

10. The printed circuit board assembly (10) according to claim 8 or 9, wherein the pins (12) are spaced 2 mm, 2.54 mm, or 3.17 mm with respect to each other.

11. The printed circuit board assembly (10) according to any of the preceding claims, wherein the diameter of each of the pins (12) is about 1 mm.

12. The printed circuit board assembly (10) according to any of claims 2 to 11, wherein the pins (12) are of copper or aluminum.

13. The printed circuit board assembly (10) according to any of claims 2 to 11, wherein at least one of the plurality of pins (12) is constituted by a lead of one of the plurality of electronic components (3).

14. The printed circuit board assembly (10) according to any of the preceding claims, wherein the length of the pins substantially corresponds to an average distance between the printed circuit board (2) and the chassis (4).
